# EUROPÄISCHE PATENTSCHRIFT

(11) **EP 2 413 354 B1**
(45) Veröffentlichungstag und Bekanntmachung des Hinweises auf die Patenterteilung: **09.01.2013**
(21) Anmeldenummer: 11172453.0
(22) Anmeldetag: 04.07.2011
(51) Int. Cl.: H01L 23/62, H01L 25/07

(54) **Submodul und Leistungshalbleitermodul**
Sub-module and power semiconductor module
Sous-module et module semi-conducteur de puissance

(30) Priorität: 30.07.2010 DE 102010038731
(43) Veröffentlichungstag der Anmeldung: 01.02.2012
(73) Patentinhaber: SEMIKRON Elektronik GmbH & Co. KG, 90431 Nürnberg (DE)
(72) Erfinder: Berberich, Sven, 91080 Spardorf (DE); Wintrich, Arendt, 90766 Fürth (DE)

(56) Entgegenhaltungen:
- EP-A1- 1 318 545

## Beschreibung

Die Erfindung betrifft ein Submodul für ein Leistungshalbleitermodul und ein Leistungshalbleitermodul

Ein Leistungshalbleitermodul weist einen oder mehrere Träger auf, auf welchem die eigentlichen Leistungshalbleiterschalter angeordnet sind. Der Träger ist in der Regel ein Substrat mit Isolierfunktion, z.B. eine DCB-Keramik (Direct Copper Bonding). Der Leistungshalbleiterschalter ist hierauf z.B. verlötet oder versintert.

Insbesondere im Falle eines Moduls mit mehreren Leistungshalbleiterschaltern bildet jeder für sich eine funktionale Einheit, nämlich ein Submodul. Zu diesem Submodul wird auch der Teil des Trägers gerechnet, der dem Leistungshalbleiterschalter zugeordnet ist. Außerdem wird dem Submodul die zur elektrischen und mechanischen Kontaktierung des Halbleiterschalters benutzte Leiterbahn des Substrats zugerechnet.

Der Leistungshalbleiterschalter ist in der Regel ein über einen Steuereingang - z.B. ein Gate - spannungsgesteuerter Transistorchip, z.B. ein IGBT (Insulated Gate Bipolar Transistor) oder MOSFET (Metal-Oxide-Semiconductor Field-Effect-Transistor).

Oft werden mehrere Leistungshalbleiterschalter auch bezüglich ihrer Gates parallel geschaltet, um gleichzeitig parallel große Lasten zu schalten. Zur Verbesserung eines derartigen synchronen Schaltens werden je Leistungshalbleiter dem Gate vorgeschaltete Vorwiderstände eingesetzt. Der Gatevorwiderstand bildet mit der Gatekapazität z.B. eines IGBT oder MOS-Transistors außerdem ein RC-Glied. Der Gatevorwiderstand dient dazu, den Spannungsanstieg des RC-Gliedes zu regeln.

Es ist bekannt, derartige Gatewiderstände im Transistorchip selbst zu integrieren. Alternativ ist bekannt, einen entsprechenden Gatewiderstand als diskretes Bauelement im Leistungshalbleitermodul vorzusehen, also z.B. neben dem Leistungshalbleiter auf dem Träger anzuordnen.

Für den Fall, dass ein Leistungshalbleiter einen Kurzschlussstrom führen und abschalten muss, steigt dessen Gatespannung bzw. -potential über den von außen, also z.B. von einem ansteuernden Treiber am Gate angelegten Spannungswert an. Grund hierfür ist eine erhöhte Ladungsträgeranreicherung am Gate. Ursache sind kapazitive Verschiebeströme im Halbleiter, z.B. zwischen Kollektor und Gate über die sogenannte Miller-Kapazität. Die effektiv anliegende höhere Gatespannung lässt wiederum im Transistor höhere Kurzschlussströme fließen, was eine erhöhte Belastung des Transistors und eine Verkürzung der zulässigen Kurzschlussdauer mit sich bringt. Im Extremfall verlässt der Transistor den sicheren Arbeitsbereich (Safe Operating Area, SOA), was die Zerstörung des Leistungshalbleiters zur Folge haben kann.

Um eine derartige unbeabsichtigte Erhöhung der Gatespannung zu verhindern, sind verschiedene Klemmschaltungen, z.B. Suppressordioden in Doppeldiodenstruktur zwischen Gate und Emitter eines IGBT, bekannt. Bei ansteigender Gatespannung über einen bestimmten Wert werden die Suppressordioden leitend und führen die überschüssige Ladung ab bzw. begrenzen so die Gatespannung auf das Niveau der Durchbruchsspannung der Dioden. Die Doppeldiodenstruktur ist also parallel zum Gate des spannungsgesteuerten Leistungsschalters geschaltet und dient dazu, das Spannungsniveau bei Erreichen einer bestimmten Spannung zu fixieren.

Als Ausführungsvarianten für Doppeldiodenstrukturen sind Clampingdioden oder Suppressordioden geeignet. Im Anschaltfall, d.h. bei einer Spannungsrampe der Gatespannung von 0V auf z.B. +15V wird der Anstieg des Ladestroms zunächst durch den Gatewiderstand begrenzt. Der Doppeldiodenstrompfad ist zunächst hochohmig. Bei Erreichen der Durchbruchspannung der Doppeldiode jedoch (z.B. 16V), wird der Doppeldiodenstrompfad niederohmig. Ein weiterer Ladestrom führt dann nicht mehr zur Erhöhung der am Gate des Leistungsschalters anliegenden Spannung, sondern der Wert ist auf z.B. 16V fixiert. Für andere Ansteuerspannungen ist die Durchbruchspannung so zu wählen, dass die jeweils knapp über der Ansteuerspannung liegt. Der Ausschaltfall verläuft analog, nur mit dem Unterschied, dass die ansteuernde Spannung auf 0V oder eine negative Spannung verändert wird. Im Fall der Suppressordiode wird die negative Gatespannung auf ca. -16V begrenzt. Im Fall einer Clampingdiode liegt der Durchbruchsspannungswert in Rückwärtsrichtung bei ca. -20V. In Rückwärtsrichtung dient die Diode als Durchbruchschutz des Gateoxids im Fehlerfall.

Bekannt ist es, die Dioden als diskrete Bauelemente auszuführen und auf einer vom Leistungshalbleitermodul unterschiedlichen externen Leiterplatte, z.B. der dem Leistungshalbleiter zugeordneten Treiberschaltung, zu montieren.

Bei den bekannten Leistungshalbleitermodulen befinden sich daher zwischen dem Gate des Leistungshalbleiters und den Suppressordioden Leitungs- bzw. elektrische Verbindungen wie Anschlussdrähte oder Anschlussfedern, Leiterbahnen von DCB Keramiken und Leiterplatten. Auch sind ggf. Bauelemente, z.B. der diskrete Gatewiderstand, zwischengeschaltet. Jedes Bauelement und jede Leitungsverbindung verursacht zusätzliche Spannungsabfälle zwischen Gate und Suppressordioden.

Die genannten Verbindungselemente besitzen eine zumindest parasitäre Induktivität bzw. ohmschen Widerstand. Dort werden, besonders bei schnellen Schaltvorgängen am Gate, Spannungen induziert. Grund hierfür ist z.B. der oben beschriebene Verschiebestrom. Sämtliche verursachten parasitären Spannungen addieren sich zur Klemmspannung der Suppressordioden. Die effektiv geklemmte Spannung am Gate steigt über die Klemmspannung der Suppressordioden an. Diese verlieren an Wirksamkeit oder werden im schlimmsten Fall unwirksam.

Es ist darüber hinaus aus der EP 1 318 545 A1 bekannt ein Leistungshalbleiter-Submodul umfassend zwischen zwei Hauptanschlüssen wenigstens zwei Halbleiterchips auszubilden. Die Halbleiterchips umfassen hierbei zwei Hauptelektroden, wobei auf eine Hauptelektrode durch einen Kontaktstempel eine Kontaktkraft ausgeübt wird und der Halbleiterchip so mit der anderen Hauptelektrode auf eine Grundplatte gedrückt wird. Durch Parallelschaltung mehrerer derartiger Submodule wird ein Leistungshalbleiter-Modul ausgebildet.

Aufgabe der vorliegenden Erfindung ist es, ein verbessertes Leistungshalbleitermodul anzugeben.

Gemäß der Erfindung wird ein Submodul für ein Leistungshalbleitermodul mit den Merkmalen des Anspruchs 1 vorgeschlagen. Das Submodul umfasst zumindest einen Teil eines Trägers und eine auf dem Träger angeordnete Leiterbahn. Auf dem Träger bzw. der Leiterbahn ist eine monolithisch integrierte Halbleiterstruktur aufgebracht. Diese weist eine Kontaktierungsfläche zur Verbindung mit der Leiterbahn und damit auch dem Träger auf. Die mechanische und ggf. elektrische Verbindung der Halbleiterstruktur zum Träger bzw. der Leiterbahn geschieht also über die Kontaktierungsfläche.

Die Halbleiterstruktur weist einen ersten und zweiten Anschluss auf und einen zwischen diese Anschlüsse geschalteten integrierten ohmschen Widerstand. Die Halbleiterstruktur weist außerdem einen dritten Anschluss und eine zwischen zweiten und dritten Anschluss geschaltete integrierte Doppeldiodenstruktur auf.

Die Erfindung beruht auf der Idee, die Beschaltungsdioden für eine optimale Wirksamkeit direkt, d.h. so nahe wie möglich und als erstes Bauelement - d.h. vor einem gegebenenfalls zusätzlichen Vorwiderstand - am Gate des Leistungshalbleiters anzubringen. Sie wird daher vorteilhafterweise für Leistungshalbleiterschalter ohne internen Gate-Vorwiderstand verwendet. Die Diodenbeschaltung befindet sich dann direkt zwischen den Ansteuerklemmen, z.B. Gate und Emitter eines IGBT in unmittelbarer Nähe zum Transistor bzw. Leistungshalbleiterchip. So soll die Wirksamkeit der Klemmschaltung im Vergleich zu einer Lösung auf einer externen Leiterplatte erhöht werden.

Denkbar wäre es zwar auch, diskrete Klemmdioden als SMD-Bauelemente (Surface Mounted Devices) innerhalb des Leistungshalbleitermoduls, d.h. auf dem Träger, anzuordnen. Die oben genannten parasitären Induktivitäten werden so verringert. Bekannt ist es jedoch, ein Leistungshalbleitermodul bzw. dessen elektrische Kontaktierungen im Sinterverfahren herzustellen. Nachteilig hierbei ist dann, dass durch die zwangsweise Verlötung der Klemmdioden auf dem Träger ein zur Sintertechnik zusätzlicher Technologieschritt, nämlich ein Lötschritt, notwendig ist. SMD-Bauelemente sind damit für existierende bzw. zukünftige gesinterte Leistungshalbleitermodule nur unvorteilhaft einsetzbar.

Desweiteren weisen SMD-Bauelemente höhere parasitäre Kenngrößen, wie elektrischen Widerstand und Induktivität auf als monolithisch integrierte Bauelemente.

Gemäß der Erfindung wird also eine monolithisch integrierte Struktur vorgeschlagen, welche sowohl einen Vorwiderstand, z.B. Gatewiderstand, als auch Suppressordioden bzw. Beschaltungsdioden enthält. Am zweiten Anschluss sind die Doppeldiodenstruktur und der ohmsche Widerstand miteinander verbunden. Erfindungsgemäß wird die integrierte Struktur als Submodul ausgeführt, um direkt benachbart zum Leistungshalbleiter bzw. dem durch diesen gebildeten Submodul auf dem Träger angeordnet zu werden. Dadurch, dass am zweiten Anschluss die Diodenstruktur noch vor dem Ohmschen Widerstand zugänglich ist, wird bei Anschluss von zweitem und drittem Anschluss die Diodenstruktur in unmittelbarer Nähe des Leistungshalbleiters platziert. Die Begrenzungs- bzw. Durchbruchsspannung der Doppeldiodenstruktur steht damit direkt am Gate als Begrenzungsspannung für Gatespannungen zur Verfügung.

Mit anderen Worten enthält das Submodul also den Gatevorwiderstand monolithisch integriert mit einer Doppeldiodenstruktur in einem einzigen Halbleiterchip.

Das erfindungsgemäße Submodul ist aufgrund der drei Anschlüsse als Dreipol ausgeführt. Der erste Anschluss dient als Ansteueranschluss, z.B. für einen externen Gate-Treiber, und kann damit bezüglich des Moduls als Gate-Anschluss G verstanden werden. Der zweite Anschluss dient zur Verbindung mit dem eigentlichen Gate des Leistungshalbleiters, also eines spannungsgesteuerten Leistungsschalters, und wird als Anschluss G' bezeichnet. Der dritte Anschluss wird auf den Emitter des Leistungshalbleiters geführt und damit als Anschluss E bezeichnet.

Der monolithisch mit der Doppeldiode integrierte Gatewiderstand ist z.B. als metallische Leiterbahn oder dotierte Polysiliziumbahn mit definierter Geometrie und materialabhängigem Leitwert ausgeführt. Der Leitwert der Polysiliziumbahn kann zusätzlich über die Dotierungskonzentration eingestellt werden. Die metallische Leiterbahn kann z.B. aus Al, AlSi, AlSi-Cu, Cu, Ti, Ni, W, Au, Ag, Pt oder Pd ausgeführt sein. Prinzipiell müssen die Leiterbahnen, die den Widerstand definieren, sowie deren Kontaktanschlüsse, insbesondere der erste Anschluss, von der Doppeldiodenstruktur und dem zweiten und dritten Anschluss dielektrisch isoliert sein. Dies kann bspw. durch eine Siliziumdioxidschicht oder -nitritschicht realisiert werden. Ein typischer Gatevorwiderstandswert liegt im Bereich 1-500hm. Die Doppeldiodenstruktur, z.B. als PNP- oder NPN-Struktur, ist im Halbleitervolumen, z.B. Silizium, realisiert. Die beiden Dioden der Doppeldiodenstruktur können bspw. als Avalanche-, Schottky- oder Zenerdioden ausgeführt sein. Denkbar ist auch eine Reihenschaltung einer Vielzahl von Einzeldioden.

In einer bevorzugten Ausführungsform der Erfindung ist der dritte Anschluss z.B. auf eine dem Substrat zugewandte Unterseite der Halbleiterstruktur geführt. Dort befindet sich die Kontaktierungsfläche, die daher mit dem dritten Anschluss verbunden ist. Mit anderen Worten dient die Unterseite dann neben der mechanischen Verbindung auch der elektrischen Verbindung des dritten Anschlusses mit der Leiterbahn. Die Leiterbahn bildet dabei die der Halbleiterstruktur zugewandte Oberfläche des Trägers. Die Leiterbahn ist z.B. ganzflächig unterhalb der Halbleiterstruktur mit einer Fläche von zumindest deren Grundfläche ausgebildet. Dies ist insbesondere für den oben genannten Fall einer Verschaltung des dritten Anschlusses mit dem Emitter des Leistungshalbleiters sinnvoll, da auch dieser in der Regel als großflächige Kontaktierungsfläche bzw. Leiterbahn auf dem Träger des Leistungshalbleiters ausgeführt ist. Mit anderen Worten kann die Halbleiterstruktur dann direkt auf der Emitterleiterbahn auf dem Träger angeordnet werden.

In einer bevorzugten Ausführungsform der Erfindung erstreckt sich innerhalb der Halbleiterstruktur die Doppeldiodenstruktur von der dem Substrat zugewandten Unterseite der Halbleiterstruktur als Vertikalstruktur zu einer dieser gegenüberliegenden Oberseite der Halbleiterstruktur. Die Unterseite der Halbleiterstruktur bildet also eine Grundfläche und die Doppeldiodenstruktur ist als Vertikalstruktur ausgehend von dieser Grundfläche aufgebaut. Angesprochen sind hier die Verläufe der pn-Übergänge als vertikal, also parallel zur Grundfläche. Speziell in der Verbindung mit der Unterseite als drittem Anschluss ist ein entsprechendes Submodul besonders einfach aufbaubar. Die Doppeldiodenstruktur kann alternativ im Submodul auch horizontal angeordnet sein, die pn-Übergänge also im wesentlichen senkrecht zur Grundfläche verlaufen.

In einer weiteren bevorzugten Ausführungsform ist der Widerstand in der Halbleiterstruktur an der dem Substrat abgewandten Oberseite angeordnet, mit anderen Worten also gegenüber bzw. an der Gegenseite der eben genannten Grundfläche. Auch hier gilt wieder ein besonderer Vorteil in Verbindung mit der eben genannten Ausführungsform der Grundfläche als drittem Anschluss. Dann befindet sich der dritte Kontakt an der Grundfläche und erster und zweiter Kontakt an der Gegenseite der Halbleiterstruktur und damit an der dem Substrat abgewandten Oberseite. Erster und zweiter Kontakt können dann besonders einfach kontaktiert, z.B. gebondet werden.

Bei einer Kombination der o.g. Ausführungsformen befinden sich dann die Anschlüsse G und G' auf der Oberseite der Halbleiterstruktur, der Anschluss E auf der Oberseite des Substrats.

Bei einer alternativen Ausführung der pn-Übergänge als Horizontalvariante könnten sich alle drei Anschlüsse auf der Oberseite der Halbleiterstruktur befinden. Deren Unterseite dient dann lediglich zur mechanischen und thermischen Verbindung mit dem Substrat.

In einer bevorzugten Ausführungsform ist die Halbleiterstruktur als Flachquader, also flaches Plättchen gestaltet, bei dem bei dem die Kontaktierungsfläche und die dieser gegenüberliegende Oberseite Flachseiten des Plättchens sind. Ziel ist es dabei, die Bauhöhe des Submoduls gering zu halten.

In einer weiteren bevorzugten Ausführungsform weisen die Kontaktierungsfläche und/oder ein bis alle Anschlüsse eine löt- und sinterfähige Metallisierung auf. Mit anderen Worten sind ein oder mehrere Kontaktierungen des Submoduls als löt- und sinterfähige Anschlüsse ausgestaltet, was eine Integration in einen Löt- oder Sinter-Fertigungsprozess eines Leistungshalbleitermoduls ermöglicht, ohne zusätzliche Prozessschritte nötig werden zu lassen. Das Submodul kann unproblematisch in Standard-Produktionsprozesse von IGBT- oder MOSFET-Leistungshalbleitermodulen eingebunden werden.

Die Aufgabe der Erfindung wird außerdem gelöst durch ein verbessertes Leistungshalbleitermodul, welches ein Submodul gemäß den obigen Ausführungen als erstes Submodul enthält und zusätzlich einen auf dem Träger angeordneten Leistungshalbleiter, der einen Steuereingang aufweist. Der Leistungshalbleiter bildet zusammen mit dem ihm zugeordneten Abschnitt des gemeinsamen Trägers dann ein zweites Submodul. Im Leistungshalbleitermodul ist das erste Submodul in unmittelbarer Nähe zum Leistungshalbleiter auf dem Träger platziert und der Steuereingang des Leistungshalbleiters ist mit dem zweiten Anschluss des ersten Submoduls verbunden.

Im erfindungsgemäßen Leistungshalbleitermodul ergeben sich die bereits oben im Zusammenhang mit dem dort erläuterten (ersten) Submodul erläuterten Vorteile.

In einer bevorzugten Ausführungsform des Leistungshalbleitermoduls ist der Leistungshalbleiter ein über seinen Steuereingang spannungsgesteuerter Leistungshalbleiter. Besonders für derartige Leistungshalbleiter eignet sich das erfindungsgemäße Submodul zur Unterdrückung von Überspannungen am Steuereingang, wie oben erläutert.

In einer bevorzugten Ausführungsform weisen erstes und zweites Submodul, d.h. der Leistungshalbleiterschalter bzgl. des Trägers den gleichen Fertigungsprozess auf. Mit anderen Worten sind bzgl. des Leistungshalbleitermoduls erstes Submodul und Leistungshalbleiter bzw. dessen zweites Submodul beide zum Träger hin gelötet oder beide gesintert. Wie oben erläutert, ist besonders für Submodule, welche löt- und sinterfähige Kontaktierungen aufweisen, ein derartiges Leistungshalbleitermodul besonders einfach herstellbar.

Für eine weitere Beschreibung der Erfindung wird auf die Ausführungsbeispiele der Zeichnungen verwiesen. Es zeigen, jeweils in einer schematischen Prinzipskizze:
- Fig.1: ein Leistungshalbleitermodul gemäß der Erfindung,
- Fig.2: ein Submodul gemäß der Erfindung
- Fig.3: ein Ersatzschaltbild eines Leistungshalbleitermoduls mit Clamping- oder Suppressordioden,
- Fig.4: eine Kennlinie der Clamping- oder Suppressordiodenstruktur aus Fig.3.

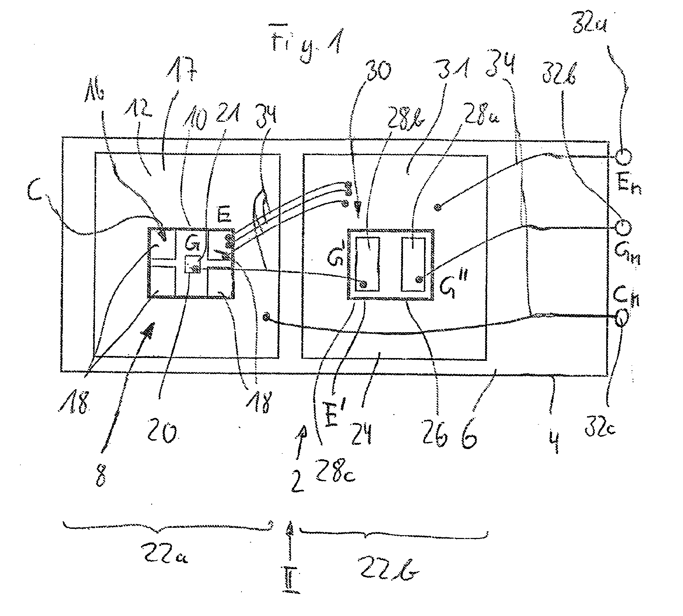

Fig. 1 zeigt eine Draufsicht auf ein Leistungshalbleitermodul 2, welches von einem Gehäuse 4 umgeben ist. Das Leistungshalbleitermodul 2 umfasst einen Träger 6 in Form eines DCB-Keramiksubstrats. Das Leistungshalbleitermodul 2 enthält einen Leistungshalbleiter 8 in Form eines Transistorchips 10, hier beispielhaft als IGBT ausgeführt. Der Leistungshalbleiter 8 ist auf eine an der Oberseite des Trägers 6 angeordnete Leiterbahn 12 des Trägers 6 aufgebracht. Leistungshalbleiter 8, Leiterbahn 12 und der diesen Teilen flächenmäßig zugeordnete teil des Trägers 6 bilden ein Submodul 22a.

An der Oberseite 16 des Leistungshalbleiters 8 sind vier Emitterfenster 18 angeordnet, die zur Kontaktierung von dessen Emitter E dienen. Außerdem ist ein Gatefenster 20 für die Kontaktierung des Gates G vorgesehen. Das Gatefenster 20 bildet hier den Steuereingang 21 des Leistungshalbleiters 8. Der Anschluss für den Kollektor C befindet sich, in Fig. 1 nicht sichtbar, an der der Oberseite 16 gegenüberliegenden Unterseite des Leistungshalbleiters 8. Der Kollektor C ist auf die Oberseite 17 der Leiterbahn 12 kontaktiert.

Erfindungsgemäß befindet sich auf dem Träger 6 neben dem Submodul 22a ein weiteres Submodul 22b. Dieses umfasst eine ebenfalls auf dem Träger 6 angeordnete Leiterbahn 24. Außerdem umfasst es eine monolithisch integrierte Halbleiterstruktur 26. Die Halbleiterstruktur 26 weist einen ersten Anschluss 28a in Form eines Kontaktes "Gate G"" und einen zweiten Anschluss 28b in Form eines Kontaktes "Gate G'" auf. Beide Anschlüsse 28a,b sind an der Oberseite 30 der Halbleiterstruktur 26 angeordnet. Ein dritter Anschluss 28c ist als Kontakt "Emitter E'" entsprechend dem Leistungshalbleiter 8 an der in Fig. 1 nicht sichtbaren Unterseite 36 der Halbleiterstruktur 26 angeordnet und auf die Oberseite 31 der Leiterbahn 24 kontaktiert.

Das Leistungshalbleitermodul 2 besitzt außerhalb des Gehäuses 4 drei Klemmen 32a-c für die elektrischen Anschlüsse "Emitter E_{M}", "Gate G_{M}" und "Kollektor C_{M}". Die Klemme 32a "Emitter E_{M}" ist über einen Bonddraht 34 mit der Oberseite 31, und damit mit dem Kontakt 28c, und diese wiederum über Bonddrähte 34 mit den Emitterfenstern 18 verbunden. Mit anderen Worten ist der Emitter E des Leistungshalbleiters 8 über den dritten Anschluss 28c auf die Klemme 32a geführt. Der Kollektor C des Leistungshalbleiters 8, welcher auf die Leiterbahn 12 geführt ist, ist über einen Bonddraht 34 mit der Klemme 32c "Kollektor C_{M}" verbunden. Das Gatefenster 20 als Gate G wiederum ist mit einem Bonddraht 34 auf den Anschluss 28b, also "G'" der Halbleiterstruktur 26 geführt, erst der Anschluss 28a "G''" ist mit der Klemme 32b "Gate G_{M}" verbunden.

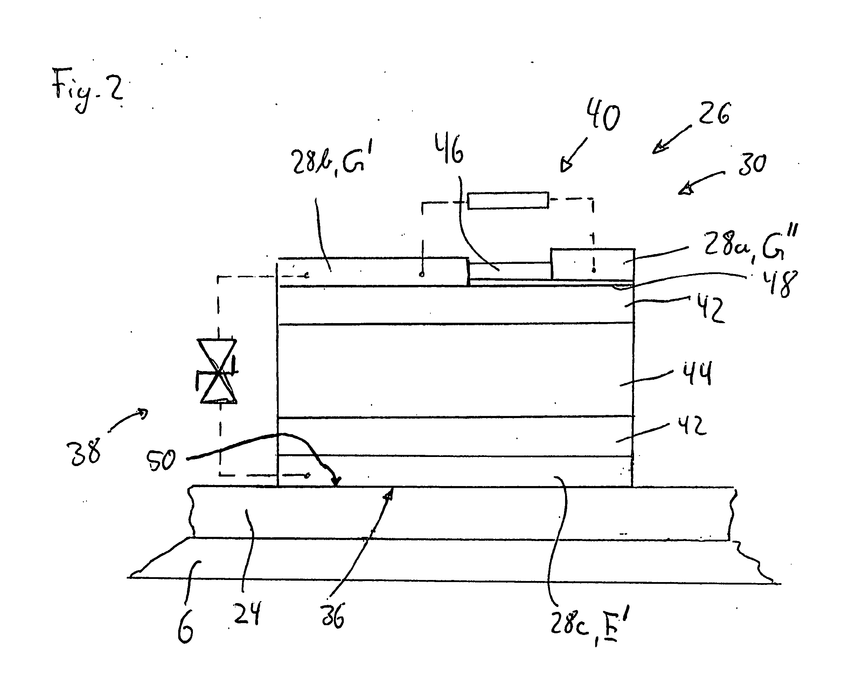

Fig. 2 zeigt einen Ausschnitt des Leistungshalbleitermoduls 2 aus Fig. 1 in Seitenansicht, d.h. in Blickrichtung des Pfeils II in Fig. 1. Insbesondere sind wieder die an der Oberseite 30 befindlichen Anschlüsse 28a,b zu sehen, nun jedoch auch der Anschluss 28c an der Unterseite 36. Fig. 2 zeigt die monolithisch integrierten Halbleiterstruktur 26 im Schnitt, welche zwei Bauelemente realisiert. Die Ersatzschaltbilder der Bauelemente sind in Fig. 2 gestrichelt angedeutet. Diese sind ein Widerstand 40 und eine Doppeldiodenstruktur 38 in Form von Clamping- bzw. Supressordioden. Die Doppeldiodenstruktur 38 ist zwischen den Anschlüssen 28b,c als pnp-Übergang zwischen zwei p-Gebieten 42 und einem n-Gebiet 44 realisiert. Die Doppeldiodenstruktur 38 ist als Vertikalstruktur angelegt, so dass diese sich schichtweise zwischen der Unterseite 36 und der Oberseite 30 erstreckt.

Zwischen den Anschlüssen 28a,b ist der Widerstand 40 als integrierte Widerstandsbahn 46 realisiert, welche durch eine Isolatorschicht 48 von der restlichen Halbleiterstruktur 26 getrennt ist.

Eine Kontaktierungsfläche 50 befindet sich an der Unterseite 36, d.h. der dem Träger 6 zugewandten Seite der Halbleiterstruktur 26. Die Kontaktierungsfläche 50 kontaktiert bzw. befestigt Halbleiterstruktur 26 auf dem Träger 6 bzw. dessen Leiterbahn 24. Im vorliegenden Beispiel ist die Kontaktierungsfläche 50 die jenige des Anschlusses 28c, bildet also auch den Kontakt "Emitter E" der Halbleiterstruktur 26.

Die Kontaktierungsfläche 50 ist löt- und sinterfähig ausgeführt, so dass das Submodul 22b bzw. die Halbleiterstruktur 26 im gleichen Fertigungsprozess wie das Submodul 22a, also der Leistungshalbleiter 8 auf dem Träger 6 montiert werden kann, egal ob letzteres in Löt- oder Sintertechnik geschieht.

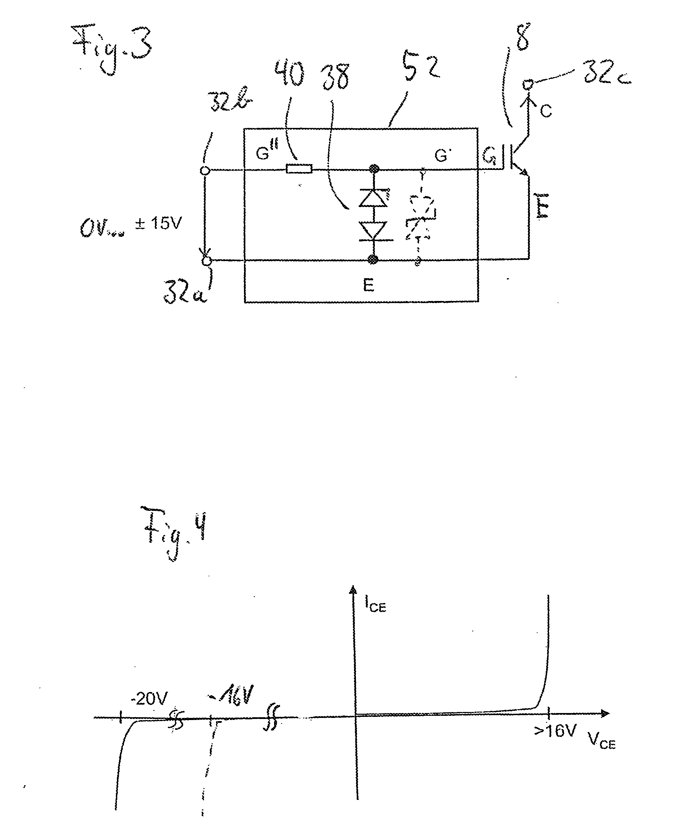

Fig. 3 zeigt ein Ersatzschaltbild zu Fig. 1, also das Ersatzschaltbild 52 (umrahmt) der Halbleiterstruktur 26 bei Anschluss am Leistungshalbleiter 8. Fig. 3 in Verbindung mit Fig. 1 lässt erkennen, dass die Doppeldiodenstruktur 38, hier in der Ausführung als Clampingdiode noch vor dem Widerstand 40 am Gate G und Emitter E des Leistungshalbleiters 8 in dessen unmittelbarer Nähe angeordnet ist.

Fig. 4 zeigt eine Kennlinie bzw. Charakteristik der Diodenstruktur 38 mit einer Begrenzung der Gatespannung am positiven Ast bei etwa 16V und in Gegenrichtung bei ca. -20V, die Werte sind hierbei als ungefähre Werte zu verstehen. Andere Spannungswerte sind bei entsprechenden anderen Ansteuerspannungen möglich. Im Fehlerfall wird durch den Negativzweig der Kennlinie einen Durchbruchschutz des Gateoxids im Leistungshalbleiter 8 gewährleistet.

Gestrichelt ist in Fig. 3 alternativ die Realisierung der Doppeldiodenstruktur 38 mit Supressordioden gezeigt, deren Kennlinie in Fig. 4 ebenfalls gestrichelt dargestellt ist. Die Kennlinien decken sich im Positivzweig nahezu. Im Negativzweig liegt die Durchbruchspannung im Gegensatz zur Clampingdiode bei etwa nur -16V.

## Patentansprüche

1. Submodul (22b) für ein Leistungshalbleitermodul (2),
- mit zumindest einem Teil eines Trägers (6),
- mit einer auf dem Teil des Trägers (6) angeordneten Leiterbahn (24),
- mit einer auf der Leiterbahn (24) aufgebrachten monolithisch integrierten Halbleiterstruktur (26), wobei die Halbleiterstruktur (26)
- erste, zweite und dritte Anschlüsse (28 a/b/c),
- eine diese Halbleiterstruktur (26) mit der Leiterbahn (24) verbindende Kontaktierungsfläche (50),
- einen ersten (28a) und zweiten Anschluss (28b) und einen zwischen diese Anschlüsse (28a,b) geschalteten integrierten ohmschen Widerstand (40), und
- einen dritten Anschluss (28c) und eine zwischen diesen (28c) und den zweiten Anschluss (28b) geschaltete integrierte Doppeldiodenstruktur (38) enthält.

2. Submodul (22b) nach Anspruch 1, bei dem der dritte Anschluss (28c) mit der Kontaktierungsfläche (50) verbunden ist.

3. Submodul (22b) nach einem der vorhergehenden Ansprüche, bei dem sich in der Halbleiterstruktur (26) die Doppeldiodenstruktur (38) von der der Leiterbahn (24) zugewandten Unterseite (36) als Vertikalstruktur zu einer dieser gegenüberliegenden Oberseite (30) erstreckt.

4. Submodul (22b) nach einem der vorhergehenden Ansprüche, bei dem der Widerstand (40) in der Halbleiterstruktur (26) an der der Leiterbahn (24) abgewandten Oberseite (30) angeordnet ist.

5. Submodul (22b) nach einem der vorhergehenden Ansprüche, bei dem die Halbleiterstruktur (26) als Flachquadevr in Form eines flachen Plättchens gestaltet ist, bei dem die Kontaktierungsfläche (50) und die dieser gegenüberliegende Oberseite (30) Flachseiten des Plättchens sind.

6. Submodul (22b) nach einem der vorhergehenden Ansprüche, bei dem die Kontaktierungsfläche (50) und/oder ein bis alle Anschlüsse (28a-c) eine löt- und sinterfähige Metallisierung aufweisen.

7. Leistungshalbleitermodul (2),
- mit einem ersten Submodul (22b) gemäß einem der Ansprüche 1 bis 6, und
- mit einem einen Steuereingang (21) aufweisenden, auf dem Träger (6) angeordneten, und mit diesem ein zweites Submodul (22a) bildenden Leistungshalbleiter (8), bei dem
- das erste Submodul (22b) in unmittelbarer Nähe zum Leistungshalbleiter (8) auf dem Träger (6) platziert ist, und
- der Steuereingang (21) mit dem zweiten Anschluss (28b) des ersten Submoduls (22b) verbunden ist.

8. Leistungshalbleitermodul (2) nach Anspruch 7, bei dem der Leistungshalbleiter (8) ein über seinen Steuereingang (21) spannungsgesteuerter Leistungshalbleiter ist.

## Claims

1. A submodule (22b) for a power semiconductor module (2),
- with at least a part of a mount (6),
- with a conducting path (24) arranged on the part of the mount (6),
- with a monolithically integrated semiconductor structure (26) introduced onto the conducting path (24), wherein
the semiconductor structure (26) contains:
- first, second and third terminal connections (28 a/b/c),
- a contact surface (50) connecting this semiconductor structure (26) with the conducting path (24),
- a first (28a) and a second terminal connection (28b), and an integrated ohmic resistance (40) electrically connected between these terminal connections (28a,b),
- a third terminal connection (28c), and an integrated double diode structure (38) electrically connected between the third terminal connection (28c) and the second terminal connection (28b).

2. A submodule (22b) in accordance with Claim 1, in which the third terminal connection (28c) is connected with the contact surface (50).

3. The submodule (22b) in accordance with one of the preceding claims, in which the double diode structure (38) extends within the semiconductor structure (26) as a vertical structure from the lower face (36) that faces towards the conducting path (24) to an upper face (30) that is located opposite to the lower face (36).

4. The submodule (22b) in accordance with one of the preceding claims, in which the resistance (40) in the semiconductor structure (26) is arranged on the upper face (30) that faces away from the conducting path (24).

5. The submodule (22b) in accordance with one of the preceding claims, in which the semiconductor structure (26) is configured as a flat quadrilateral in the form of a flat platelet, in which the contact surface (50) and the upper face (30) located opposite to the latter are flat faces of the platelet.

6. The submodule (22b) in accordance with one of the preceding claims, in which the contact surface (50) and/or one to all terminal connections (28a-c) are metallised such that they can be soldered and sintered.

7. A power semiconductor module (2),
- with a first submodule (22b) in accordance with one of the Claims 1 to 6, and
- with a power semiconductor (8), having a control input (21), arranged on the mount (6), and forming with the latter a second submodule (22a), in which
- the first submodule (22b) is positioned on the mount (6) in the immediate vicinity of the power semiconductor (8), and
- the control input (21) is connected with the second terminal connection (28b) of the first submodule (22b).

8. The power semiconductor module (2) in accordance with Claim 7,
in which the power semiconductor (8) is a power semiconductor that is voltage-controlled via its control input (21).

## Revendications

1. Sous-module (22b) pour un module semi-conducteur de puissance (2) comprenant :
- au moins une partie d'un support (6),
- une piste conductrice (24) disposée sur la partie du support (6),
- une structure semi-conductrice intégrée monolithique (26) appliquée sur la piste conductrice (24), la structure semi-conductrice (26) comprenant :
- des première, deuxième et troisième connexions (28 a/b/c),
- une surface de contact (50) reliant cette structure semi-conductrice (26) à la piste conductrice (24),
- une première connexion (28a) et une deuxième connexion (28b) et une résistance ohmique intégrée (40) connectée entre ces deux connexions (28a,b), et
- une troisième connexion (28c) et une structure de diode double intégrée (38) connectée entre cette connexion (28c) et la deuxième connexion (28b).

2. Sous-module (22b) selon la revendication 1, dans lequel la troisième connexion (28c) est reliée à la surface de contact (50).

3. Sous-module (22b) selon l'une quelconque des revendications précédentes, dans lequel la structure de diode double (38) s'étend dans la structure semi-conductrice (26) de la face inférieure (36) dirigée vers la piste conductrice (24), en tant que structure verticale, vers une face supérieure (30) opposée à ladite face inférieure.

4. Sous-module (22b) selon l'une quelconque des revendications précédentes, dans lequel la résistance (40) à l'intérieur de la structure semi-conductrice (26) est disposée au niveau de la face supérieure (30) opposée à la piste conductrice (24).

5. Sous-module (22b) selon l'une quelconque des revendications précédentes, dans lequel la structure semi-conductrice (26) est réalisée en tant que parallélépipède plat sous la forme d'une plaquette plate, la surface de contact (50) et la face supérieure (30) opposée à celle-ci formant les côtés plats de la plaquette.

6. Sous-module (22b) selon l'une quelconque des revendications précédentes, dans lequel la surface de contact (50) et/ou une à toutes les connexions (28a-c) présentent une métallisation apte à la soudure et au frittage.

7. Module semi-conducteur de puissance (2) comprenant :
- un premier sous-module (22b) selon l'une quelconque des revendications 1 à 6, et
- un semi-conducteur de puissance (8) présentant une entrée de commande (21), disposé sur le support (6) et formant avec celui-ci un deuxième sous-module (22a),
dans lequel :
- le premier sous-module (22b) est placé sur le support (6) à proximité immédiate du semi-conducteur de puissance (8), et
- l'entrée de commande (21) est reliée à la deuxième connexion (28b) du premier sous-module (22b).

8. Module semi-conducteur de puissance (2) selon la revendication 7, dans lequel le semi-conducteur de puissance (8) est un semi-conducteur de puissance commandé en tension par l'intermédiaire d'une entrée de commande (21).
